# FASCICULE DE BREVET EUROPEEN

(11) **EP 4 461 108 B1**
(45) Date de publication et mention de la délivrance du brevet: **21.10.2026**
(21) Numéro de dépôt: 23700072.4
(22) Date de dépôt: 05.01.2023
(51) Int. Cl.: H10N 30/01, H10N 30/071, H10N 30/072, H10N 30/073, H10N 30/074, H10N 30/853

(54) **PROCÉDÉ DE TRAITEMENT DE SUBSTRATS**
VERFAHREN ZUR BEHANDLUNG VON SUBSTRATEN
METHOD FOR PROCESSING SUBSTRATES

(30) Priorité: 07.01.2022 FR 2200119
(43) Date de publication de la demande: 13.11.2024
(73) Titulaire: SOITEC, 38190 Bernin (FR)
(72) Inventeur: BERTRAND, Isabelle, 38190 Bernin (FR); BELHACHEMI, Djamel, 38190 Bernin (FR); LANDRU, Didier, 38190 Bernin (FR); GIRAUD, Dorothée, 38190 Bernin (FR); MOUREY, Odile, 38190 Bernin (FR)
(74) Mandataire: IP Trust
(86) Numéro de dépôt international: PCT/EP2023/050191
(87) Numéro de publication internationale: WO 2023/131654

(56) Documents cités:
- WO-A1-2021/225102
- FR-A1- 3 045 677
- SCHMIDT F. PAUL: "CONTAMINATION-FREE HIGH TEMPERATURE TREATMENTS", JOURNAL OF THE ELECTROCHEMICAL SOCIETY, 1 January 1983 (1983-01-01), pages 196 - 199, XP093298873, Retrieved from the Internet <URL:https://iopscience.iop.org/article/10.1149/1.2119656/meta?casa_token=XlqIBul0KnEAAAAA:OrZO3DO00RraGCLLB0R1QeGjJ7Sp5A4Y5RPYTscLIIrtbZCG3U86nwkNDVMKSIOuzq8ctStdE928QEZA6Tb_kW5G3w> DOI: 10.1149/1.2119656
- BUTAUD E ET AL: "Innovative Smart Cut(TM) Piezo On Insulator (POI) Substrates for 5G acoustic filters", 2020 IEEE INTERNATIONAL ELECTRON DEVICES MEETING (IEDM), IEEE, 12 December 2020 (2020-12-12), XP033886048, DOI: 10.1109/IEDM13553.2020.9372020

## Description

L'invention concerne un procédé de traitement de substrats, et plus en particulier un procédé de traitement de substrats semi-conducteurs et/ou de substrats piézoélectriques.

Lors de traitements thermiques dans des procédés utilisant des substrats semi-conducteur et/ou piézoélectrique, la diffusion d'un élément métallique, tel que par exemple le lithium, peut aboutir à une contamination de l'équipement réalisant le traitement thermique, tel qu'un four. Le niveau de contamination par cet élément peut par exemple être déterminé par VPD ICP-MS (de l'anglais « Vapour Phase Decomposition » et « Inductively Coupled Plasma Mass Spectrometry » ou « décomposition en phase vapeur » et « Spectroscopie de masse à plasma à couplage inductif ») en nombre d'atomes par centimètre carré. Le niveau de contamination peut dépendre du nombre de cycles réalisés avec des substrats comprenant l'élément métallique, des conditions du processus utilisé et du type de substrat utilisé. Une forte augmentation du niveau de contamination est notamment observée quand un substrat se brise à l'intérieur de l'équipement. Un niveau élevé de contamination dans un équipement peut ensuite réduire le rendement de production.

Le document WO2021/225102 A1 concerne un procédé de fabrication d'un substrat composite muni d'un film monocristallin piézoélectrique, tel qu'un monocristal de tantalate de lithium, destiné à un dispositif à ondes acoustiques de surface.

La publication par BUTAUD E ET AL: "Innovative Smart Cut(TM) Piezo On Insulator (POI) Substrates for 5G acoustic filters", 2020 IEEE INTERNATIONAL ELECTRON DEVICES MEETING (IEDM), IEEE, 12 décembre 2020 (2020-12-12), DOI:10.1109/IEDM13553.2020.9372020 présente les caractéristiques physiques du substrat Smart Cut^{™} POI qui influencent les principaux indicateurs de performance des dispositifs à ondes acoustiques guidées (SAW).

Le document FR3045677 A1 montre un procédé de fabrication d'une couche monocristalline et piézoélectrique pour une application à un dispositif microélectronique, photonique ou optique.

La publication par Schmidt F. Paul: "CONTAMINATION-FREE HIGH TEMPERATURE TREATMENTS", Journal of The Electrochemical Society, 1 janvier 1983 (1983-01-01), pages 196-199, DOI: 10.1149/1.2119656 divulgue que on peut éviter toute contamination des dispositifs à semi-conducteurs en plaçant le tube de quartz dans une atmosphère protectrice de HCl dans de l'oxygène sec.

Le problème de contamination peut également avoir un impact négatif sur les chaînes de production d'un fabricant, car une contamination par un certain élément dans un équipement peut aboutir à une interdiction de réalisation de différents types de procédé sur un même équipement ce qui réduit grandement la flexibilité de fabrication et impose au fabricant la mise en place de plusieurs lignes distinctes de fabrication selon le procédé et les matériaux utilisés. L'objet de l'invention est donc la mise en place d'un procédé de décontamination qui permet de réduire le niveau de contamination par un élément métallique dans un équipement réalisant un traitement thermique.

L'objet de l'invention est réalisé avec un procédé de traitement de substrats selon la revendication indépendante de procédé 1.

Des mesures par VPD-ICP-MS ont montré que l'utilisation d'un tel substrat de décontamination lors de l'étape de décontamination permet de réduire le niveau de contamination dans l'équipement.

Selon l'invention, le substrat de décontamination utilisé pour l'étape de réduction du niveau de contamination est un substrat dédié pour l'étape de décontamination et seulement utilisé pour cette étape de décontamination. Ainsi, le substrat de décontamination n'est pas présent dans l'équipement réalisant un traitement thermique lors des étapes de traitement thermique du premier substrat et du deuxième substrat. De même ni le premier substrat ni le deuxième substrat sont présents dans l'équipement réalisant un traitement thermique lors de l'étape de décontamination.

Selon un mode de réalisation, le premier et le second substrat peuvent être de matériaux différents. Selon un mode de réalisation, le premier substrat peut être un substrat piézoélectrique choisi parmi le lithium niobate (LiNbO₃) et le lithium tantalate (LiTaO₃) et/ou le second substrat peut être un substrat semi-conducteur choisi parmi le silicium, le carbure de silicium (SiC), le saphir (Al₂O₃) ou un substrat semi-conducteur III-V, en particulier l'arséniure de gallium (GaAs). En utilisant un substrat de décontamination, il devient ainsi possible d'utiliser le même équipement réalisant un traitement thermique pour deux types de substrat différents. Ainsi différents types de produits, tels que des substrats de type silicium sur isolant (SOI) et piézoélectrique sur isolant (POI) peuvent être réalisés utilisant le même équipement. Selon un mode de réalisation, l'élément métallique contaminant est le lithium. La présence de lithium est proscrite dans des procédés de types silicium et même dans des procédés utilisant des substrats de lithium niobate (LiNbO₃) ou lithium tantalate (LiTaO₃) seuls ou en combinaison avec des substrats à base de silicium, un niveau trop élevé de lithium peut aboutir à une baisse de rendement de production. Le procédé selon l'invention est efficace pour réduire le niveau de lithium dans l'équipement.

Selon un mode de réalisation, le procédé peut comprendre avant et/ou après l'étape de décontamination une étape de détermination du niveau de contamination d'au moins un composant contaminant à l'intérieur de l'équipement réalisant un traitement thermique. La connaissance du niveau de contamination, par exemple en réalisant des mesures de VPD-ICPMS sur un substrat de décontamination, permet d'adapter les paramètres de la réalisation de l'étape de décontamination, par exemple la durée, la température et/ou l'atmosphère appliquée, ou de vérifier le résultat de l'étape de décontamination.

Selon un mode de réalisation, l'étape de décontamination peut être réalisée si le niveau de contamination excède un seuil de contamination prédéterminé. Ainsi l'étape de décontamination peut seulement être réalisée si nécessaire.

Selon un mode de réalisation, l'étape de décontamination peut être réalisée à une température d'au moins 500°C, en particulier au moins 800°C. L'effet décontamination est plus efficace à partir de ces températures.

Selon l'invention l'étape de décontamination est réalisée sous une atmosphère oxydante, en particulier en introduisant de l'oxygène. L'effet décontamination est plus efficace sous une atmosphère oxydante.

Selon un mode de réalisation l'étape de décontamination peut être réalisée pendant une durée prédéterminée, en particulier pendant au moins 30 minutes, plus en particulier pendant au moins 1 heure. Ces durées permettent une décontamination encore plus efficace.

Selon un mode de réalisation l'étape de décontamination peut être répétée avant de continuer avec l'étape de traitement du deuxième substrat au moins une fois en utilisant en particulier à chaque répétition un nouveau substrat de décontamination. La répétition de l'étape avec un substrat de décontamination nouveau permet d'augmenter l'efficacité de la décontamination.

Selon un mode de réalisation, le substrat de décontamination peut être mis au rebut après le traitement thermique. Ainsi on réduit le risque d'une ré-contamination de l'équipement.

L'objet de l'invention est également réalisé par l'utilisation d'un substrat silicium comme substrat de décontamination dans un procédé tel que décrit ci-dessus. Tous les avantages du procédé tels que décrit ci-dessus peuvent être réalisés par l'utilisation d'un substrat silicium.

L'invention et ses avantages seront expliqués plus en détail dans la suite au moyen de modes de réalisation avantageux exemplaires et en s'appuyant notamment sur les figures d'accompagnement suivantes, dans lesquelles les numéros de référence identifient des caractéristiques de l'invention.

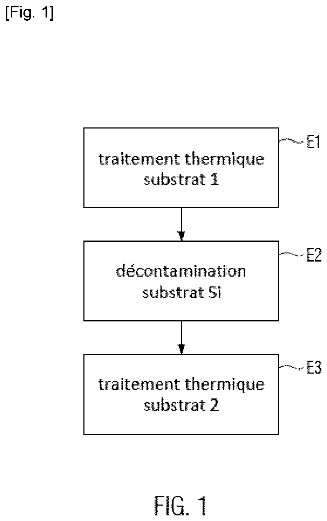

Figure 1 représente schématiquement un procédé de traitement d'un substrat selon un mode de réalisation,

L'invention va être décrite plus en détail en utilisant des modes de réalisation avantageux d'une manière exemplaire et en référence aux dessins. Les modes de réalisation décrits sont simplement des configurations possibles et il faut garder à l'esprit que les caractéristiques individuelles telles que décrites ci-dessus peuvent être fournies indépendamment les unes des autres ou peuvent être omises tout à fait lors de la mise en oeuvre de la présente invention.

La Figure 1 représente schématiquement un procédé de traitement d'un substrat selon un mode de réalisation.

Lors de l'étape E1 un traitement thermique est réalisé sur un premier substrat dans un équipement réalisant un traitement thermique. Le premier substrat est un substrat comprenant un matériau semi-conducteur ou un matériau piézoélectrique.

Selon le procédé du premier mode, le premier substrat est un substrat piézoélectrique choisi parmi le lithium niobate (LiNbO₃) et le lithium tantalate (LiTaO₃). L'équipement peut, par exemple, être un four pour chauffer un ou plusieurs substrats, ou un réacteur de dépôt, par exemple une chambre de dépôt chimique en phase vapeur (« CVD » en anglais).

Le traitement thermique peut être un traitement de recuit, un traitement thermique nécessaire lors d'un dépôt de couche, un traitement de fracturation lors d'un procédé de transfert de couche sur un substrat support pour réaliser un substrat POI, par exemple un procédé tel que connu sous le nom de SmartCut^{®}, ou tout autre traitement nécessitant une température supérieure à la température ambiante, c'est-à-dire une température d'environ 20°C à 25°C. Sont, en particulier, concernés des traitements à des températures au-delà de 500°C.

Il est connu qu'une contamination de l'équipement thermique par des atomes de lithium peut avoir lieu suite à des phénomènes de diffusion lors d'un tel traitement thermique. Le niveau de contamination dans l'équipement dépend du nombre de cycles réalisés avec des premiers substrats, des conditions du processus utilisé et du type de premier substrat utilisé. Une forte augmentation de la contamination est observée quand un substrat se brise à l'intérieur de l'équipement, que ce soit accidentellement ou volontairement, par exemple lors d'une étape de fracturation.

Selon l'invention, une étape E2 de décontamination est ensuite réalisée pour réduire le niveau de contamination dans l'équipement réalisant le traitement thermique. Pour réduire la présence de lithium dans l'équipement, un substrat de décontamination est introduit dans l'équipement. Selon le premier mode de réalisation un substrat de silicium est utilisé. Il s'agit d'une plaquette de silicium avec ou sans son oxyde naturel. Le substrat de silicium est introduit à une température d'environ 350°C et ensuite chauffé à au moins 500°C, de préférence à au moins 800°C. Cette température est maintenue pendant au moins 30 minutes, de préférence pendant au moins une heure. Cette étape de décontamination est réalisée sous une atmosphère oxydante, en particulier en introduisant de l'oxygène dans l'équipement.

Le substrat de décontamination est ensuite mis au rebut pour éviter une nouvelle contamination lors d'une réintroduction dans l'équipement.

Des mesures de VPD ICPMS ont été appliquées sur un nouveau substrat silicium introduit dans l'équipement après l'étape E2 et chauffé de la même manière à au moins 500°C, de préférence au moins 800°C, sous une atmosphère oxydante pendant au moins 30 minutes, de préférence au moins 1 heure. Ces mesures ont montré une baisse de la densité surfacique de lithium par rapport à la même mesure sur le substrat silicium utilisé lors de l'étape E2. Les mesures de VPD ICPMS fonctionnent comme suit : décomposition de la couche d'oxyde naturelle par gravure, en particulier en utilisant du HF en phase vapeur, après balayage de la surface avec 150µL d'une solution de HF/HNO₃ et ensuite dilution de cette solution dans 250µL d'une solution HF/HNO₃ avant l'analyse ICPMS.

Après l'étape de décontamination E2, le procédé se poursuit avec l'étape E3 qui est un procédé de traitement d'un deuxième substrat. Le deuxième substrat peut être un substrat comprenant un matériau semi-conducteur ou un matériau piézoélectrique. Il peut s'agir du même matériau que pour le premier substrat ou d'un autre matériau.

Si le même matériau est utilisé, le traitement du deuxième substrat peut être le même que pour le premier substrat, ou un autre.

Si un autre matériau est utilisé, il peut, à titre d'exemple, s'agir un substrat semi-conducteur choisi parmi le silicium, le carbure de silicium (SiC), le saphir (Al₂O₃) ou un substrat semi-conducteur III-V, en particulier l'arséniure de gallium (GaAs).

Le traitement du deuxième substrat comprend au moins une étape réalisée également dans l'équipement réalisant le traitement thermique. Etant donné que l'équipement a été décontaminé au préalable, la qualité du traitement du deuxième substrat n'est pas, ou est moins, impactée par le contaminant, en l'occurrence le lithium. Ceci permet d'obtenir un gain de rendement, en comparaison avec un procédé sans l'étape de décontamination. Comme pour le premier substrat, le traitement thermique peut être un traitement de recuit, un traitement thermique nécessaire lors d'un dépôt de couche, un traitement de fracturation lors d'un procédé de transfert de couche sur un substrat support pour réaliser un substrat SOI, par exemple un procédé tel que connu sous le nom de SmartCut^{®}, ou tout autre traitement nécessitant une température supérieure à la température ambiante, c'est-à-dire une température d'environ 20°C à 25°C. Sont en particulier concernés des traitements à des températures au-delà de 500°C.

Le substrat de décontamination utilisé pour l'étape E2 de réduction du niveau de contamination est un substrat dédié pour l'étape de décontamination et seulement utilisé pour cette étape de décontamination. Ainsi, le substrat de décontamination n'est pas présent dans l'équipement réalisant un traitement thermique lors des étapes E1 et E2 de traitement thermique du premier substrat et du deuxième substrat. De même ni le premier substrat ni le deuxième substrat sont présents dans l'équipement réalisant un traitement thermique lors de l'étape de décontamination E2.

Selon une variante du procédé selon l'invention, l'étape E2 de décontamination est répétée avant de continuer avec l'étape E3 au moins une fois, en utilisant à chaque répétition un nouveau substrat de décontamination. Ainsi le niveau de décontamination de l'équipement peut encore être amélioré car à chaque répétition de l'étape E2 des éléments contaminants sont capturés dans le substrat de décontamination. Ainsi il devient possible de réduire le niveau de contamination au-dessous d'une limite de détection du dispositif de mesure VPD ICPMS. Selon une autre variante, le procédé E2 est répété si la contamination mesurée par VPD ICPMS excède une valeur seuil de contamination prédéterminée, par exemple 1*10^13at/cm². Au lieu d'utiliser de la VPD ICPMS, il est également possible de mesurer la contamination par spectrométrie de masse des ions secondaires (également appelé « SIMS »).Le procédé selon l'invention permet de réduire la contamination d'un équipement de traitement thermique, tel qu'un four, de manière efficace et simple à mettre en œuvre en utilisant des substrats de silicium. En fonction du niveau de décontamination souhaité, le procédé peut être répété avant de continuer avec l'utilisation de l'équipement dans le procédé de fabrication suivant.

## Revendications

1. Procédé de traitement de substrats comprenant :
- une étape (E1) de traitement d'un premier substrat comprenant au moins une étape réalisée dans un équipement réalisant un traitement thermique, le premier substrat étant un substrat comprenant un matériau semi-conducteur ou un matériau piézoélectrique, ensuite
- une étape (E2) de réduction du niveau de contamination de l'équipement réalisant un traitement thermique par un élément métallique contaminant en réalisant un traitement thermique d'un substrat de décontamination seulement dédié pour ladite étape (E2) de réduction du niveau de contamination, en particulier un substrat à base de silicium, encore plus en particulier un substrat en silicium mono- ou poly- cristallin ou en silicium poreux ou en SiOCH, ladite étape (E2) étant réalisée sous une atmosphère oxydante, et ensuite
- une étape (E3) de traitement d'un deuxième substrat comprenant au moins une étape réalisée dans l'équipement réalisant un traitement thermique, le deuxième substrat étant un substrat comprenant un matériau semi-conducteur ou un matériau piézoélectrique.

2. Procédé de traitement de substrats selon la revendication 1, dans lequel le premier et le second substrat sont de matériaux différents.

3. Procédé de traitement de substrats selon la revendication 2, dans lequel le premier substrat est un substrat piézoélectrique choisi parmi le lithium niobate, LiNbO₃, et le lithium tantalate, LiTaO₃, et/ou le second substrat est un substrat semi-conducteur choisi parmi le silicium, le carbure de silicium, SiC, le saphir, Al₂O₃, ou un substrat semi-conducteur II I-V, en particulier l'arséniure de gallium, GaAs.

4. Procédé de traitement de substrats selon au moins une des revendications 1 à 3, dans lequel l'élément métallique contaminant est le lithium.

5. Procédé de traitement de substrats selon au moins une des revendications 1 à 4, comprenant avant et/ou après l'étape (E2) de décontamination une étape de détermination du niveau de contamination d'au moins un composant contaminant à l'intérieur de l'équipement réalisant un traitement thermique.

6. Procédé de traitement de substrats selon la revendication 5, dans lequel l'étape (E2) de décontamination est réalisée si le niveau de contamination excède un seuil de contamination prédéterminé.

7. Procédé de traitement de substrats selon au moins une des revendications 1 à 6, dans lequel l'étape (E2) de décontamination est réalisée à une température d'au moins 500°C, en particulier au moins 800°C.

8. Procédé de traitement de substrats selon au moins une des revendications 1 à 7, dans lequel l'étape (E2) de décontamination est réalisée en introduisant de l'oxygène dans l'équipement.

9. Procédé de traitement de substrats selon au moins une des revendications 1 à 8, dans lequel l'étape (E2) de décontamination est réalisée pendant une durée prédéterminée, en particulier pendant au moins 30 minutes, plus en particulier pendant au moins 1 heure.

10. Procédé de traitement de substrats selon au moins une des revendications 1 à 9, dans lequel l'étape (E2) de décontamination est répétée au moins une fois avant de continuer avec l'étape de traitement du deuxième substrat, en utilisant en particulier à chaque répétition un nouveau substrat de décontamination.

11. Procédé de traitement de substrats selon au moins une des revendications 1 à 10, dans lequel le substrat de décontamination est mis au rebut après le traitement thermique.

12. Utilisation d'un substrat silicium comme substrat de décontamination dans un procédé selon une des revendications 1 à 11, ledit substrat de décontamination étant dédié pour l'étape (E2) de réduction du niveau de contamination.

## Patentansprüche

1. Verfahren zum Behandeln von Substraten, umfassend:
- einen Schritt (E1) des Behandelns eines ersten Substrats, umfassend mindestens einen Schritt, der in einer eine Wärmebehandlung durchführenden Anlage durchgeführt wird, wobei das erste Substrat ein Substrat ist, umfassend ein Halbleitermaterial oder ein piezoelektrisches Material, anschließend
- einen Schritt (E2) des Reduzierens des Kontaminationsniveaus der eine Wärmebehandlung durchführenden Anlage durch ein kontaminierendes Metallelement, durch Durchführen einer Wärmebehandlung eines Dekontaminationssubstrats, das nur dem Schritt (E2) des Reduzierens des Kontaminationsniveaus gewidmet ist, insbesondere eines Substrats auf Siliziumbasis, ganz besonders eines Substrats aus mono- oder polykristallinem Silizium oder aus porösem Silizium oder aus SiOCH, wobei der Schritt (E2) unter einer oxidierenden Atmosphäre durchgeführt wird, und anschließend
- einen Schritt (E3) zum Behandeln eines zweiten Substrats, umfassend mindestens einen Schritt, der in der eine Wärmebehandlung durchführenden Anlage durchgeführt wird, wobei das zweite Substrat ein Substrat ist, umfassend ein Halbleitermaterial oder ein piezoelektrisches Material.

2. Verfahren zum Behandeln von Substraten nach Anspruch 1, wobei das erste und das zweite Substrat aus unterschiedlichen Materialien sind.

3. Verfahren zum Behandeln von Substraten nach Anspruch 2, wobei das erste Substrat ein piezoelektrisches Substrat ist, ausgewählt aus Lithiumniobat, LiNbO₃, und Lithiumtantalat, LiTaO₃, und/oder das zweite Substrat ein Halbleitersubstrat ist, ausgewählt aus Silizium, Siliziumkarbid, SiC, Saphir, Al₂O₃, oder einem III-V-Halbleitersubstrat, insbesondere Galliumarsenid, GaAs.

4. Verfahren zum Behandeln von Substraten nach mindestens einem der Ansprüche 1 bis 3, wobei das kontaminierende Metallelement Lithium ist.

5. Verfahren zum Behandeln von Substraten nach mindestens einem der Ansprüche 1 bis 4, umfassend vor und/oder nach dem Schritt (E2) des Dekontaminierens einen Schritt des Bestimmens des Kontaminationsniveaus mindestens einer kontaminierenden Komponente im Inneren der eine Wärmebehandlung durchführenden Anlage.

6. Verfahren zum Behandeln von Substraten nach Anspruch 5, wobei der Schritt (E2) des Dekontaminierens durchgeführt wird, falls das Kontaminationsniveau eine vorbestimmte Kontaminationsschwelle überschreitet.

7. Verfahren zum Behandeln von Substraten nach mindestens einem der Ansprüche 1 bis 6, wobei der Schritt (E2) des Dekontaminierens bei einer Temperatur von mindestens 500 °C, insbesondere mindestens 800 °C, durchgeführt wird.

8. Verfahren zum Behandeln von Substraten nach mindestens einem der Ansprüche 1 bis 7, wobei der Schritt (E2) des Dekontaminierens durch Einführen von Sauerstoff in die Anlage durchgeführt wird.

9. Verfahren zum Behandeln von Substraten nach mindestens einem der Ansprüche 1 bis 8, wobei der Schritt (E2) des Dekontaminierens für eine vorbestimmte Dauer, insbesondere für mindestens 30 Minuten, ganz besonders für mindestens 1 Stunde, durchgeführt wird.

10. Verfahren zum Behandeln von Substraten nach mindestens einem der Ansprüche 1 bis 9, wobei der Schritt (E2) des Dekontaminierens mindestens einmal wiederholt wird, bevor mit dem Schritt des Behandelns des zweiten Substrats fortgefahren wird, wobei insbesondere bei jeder Wiederholung ein neues Dekontaminationssubstrat verwendet wird.

11. Verfahren zum Behandeln von Substraten nach mindestens einem der Ansprüche 1 bis 10, wobei das Dekontaminationssubstrat nach der Wärmebehandlung entsorgt wird.

12. Verwendung eines Siliziumsubstrats als Dekontaminationssubstrat in einem Verfahren nach einem der Ansprüche 1 bis 11, wobei das Dekontaminationssubstrat dem Schritt (E2) des Reduzierens des Kontaminationsniveaus gewidmet ist.

## Claims

1. Method for treating substrates, comprising:
- a step (E1) for treating a first substrate, comprising at least one step performed in equipment performing heat treatment, the first substrate being a substrate comprising a semiconductor material or a piezoelectric material, then
- a step (E2) for reducing the level of contamination of the equipment performing heat treatment caused by a contaminating metal element by performing heat treatment of a decontamination substrate dedicated solely to said step (E2) for reducing the level of contamination, in particular, a silicon-based substrate, even more particularly, a substrate made of mono- or polycrystalline silicon, porous silicon, or SiOCH, said step (E2) being performed in an oxidizing atmosphere, and then
- a step (E3) for treating a second substrate, comprising at least one step performed in the equipment performing heat treatment, the second substrate being a substrate comprising a semiconductor material or a piezoelectric material.

2. Method for treating substrates according to claim 1, wherein the first and the second substrate are made of different materials.

3. Method for treating substrates according to claim 2, wherein the first substrate is a piezoelectric substrate selected from lithium niobate, LiNbO₃, and lithium tantalate, LiTaO₃, and/or the second substrate is a semiconductor substrate selected from silicon, silicon carbide, SiC, sapphire, AI₂O₃, or a II-I-V semiconductor substrate, in particular gallium arsenide, GaAs.

4. Method for treating substrates according to at least one of claims 1 to 3, wherein the contaminating metal element is lithium.

5. Method for treating substrates according to at least one of claims 1 to 4, comprising, before and/or after the decontamination step (E2), a step of determining the level of contamination of at least one contaminant within the equipment performing heat treatment.

6. Method for treating substrates according to claim 5, wherein the decontamination step (E2) is performed if the level of contamination exceeds a predetermined contamination threshold.

7. Method for treating substrates according to at least one of claims 1 to 6, wherein the decontamination step (E2) is performed at a temperature of at least 500°C, in particular at least 800°C.

8. Method for treating substrates according to at least one of claims 1 to 7, wherein the decontamination step (E2) is performed by introducing oxygen into the equipment.

9. Method for treating substrates according to at least one of claims 1 to 8, wherein the decontamination step (E2) is performed for a predetermined duration, in particular for at least 30 minutes, more particularly for at least 1 hour.

10. Method for treating substrates according to at least one of claims 1 to 9, wherein the decontamination step (E2) is repeated at least once before continuing with the step for treating the second substrate, in particular using a new decontamination substrate for each repetition.

11. Method for treating substrates according to at least one of claims 1 to 10, wherein the decontamination substrate is discarded after heat treatment.

12. Use of a silicon substrate as a decontamination substrate in a method according to any of claims 1 to 11, said decontamination substrate being dedicated to the step (E2) for reducing the level of contamination.
